# EUROPEAN PATENT SPECIFICATION

(11) **EP 2 066 103 B1**
(45) Date of publication and mention of the grant of the patent: **01.03.2017**
(21) Application number: 07291440.1
(22) Date of filing: 30.11.2007
(51) Int. Cl.: H04M 11/06, H03H 1/00, H04B 3/30

(54) **Switchable impedance xdsl splitter**
Umschaltbarer XDSL-Impedanzsplitter
Séparateur xdsl à indépendance commutable

(43) Date of publication of application: 03.06.2009
(73) Proprietor: ALCATEL LUCENT, 92100 Boulogne-Billancourt (FR)
(72) Inventor: Moesen, Kristof, 1930 Zaventem (BE)
(74) Representative: ALU Antw Patent Attorneys

(56) References cited:
- EP-A- 0 967 735
- EP-A- 1 017 218
- US-A- 6 115 466

## Description

The present invention relates to a telecommunication filter arrangement comprising a first filter cell and a second filter cell coupled in cascade between a first filter port and a second filter port, each filter cell comprising a transformer and said filter arrangement further comprising a parallel capacitor at the junction point of the two transformers and coupled between the windings of each of said transformers.

Such a telecommunication filter arrangement is already known in the art, e.g. in the field of splitters for a Digital Subscriber Line ADSL, VDSL, xDSL, ... - Plain Old Telephone Service POTS. The filter arrangement is used to prevent high frequency ADSL signals from interfering with the lower frequency POTS signals, and to prevent high frequency transients from the POTS from interfering with the ADSL signals.

A filter arrangement is generally constituted by passive LC filters with bulky coils coupled in cascade. Because of the bulky coils, the filter arrangement may have to be located on different boards, or even shelfs, which take much space/ volume per telecommunication line and consequently leads to a relatively high cost.

A first solution to reduce this cost and the high volume per line is proposed by the European Patent EP 0 967 736 B1. Therein, a switched capacitor is used to change the filter arrangement characteristics when the phone POTS goes off-hook, as well as to reduce the effect of multiple filters on a line. It may for instance change the filter arrangement from a 2^{nd} order filter to a 4^{th} order filter, and vice versa.

Such a known filter arrangement remains bulky, costly and relatively complex mainly because of the presence of the switched capacitor.

Another solution is proposed by the European Patent EP 1 783 996 B1. Therein, another filter cell is coupled in parallel between the winding of the transformers of the first and second filter cells, at their junction points. This other filter cell consists of another capacitor and an inductor coupled in series. The inductor is shunted by a resistor.

This solution allows obtaining a 3^{rd} order filter at relatively low cost, not complex, of a relatively small size, and with good transient performance.
US 6 115 466 A describes a Dual-mode filter network for a DSL splitter. The mode depends from the state of the telephone line (on hook or off hook). EP 1 017 218 A discloses an Off hook detector using current voltage transformer circuit. EP 0 967 735 A describes a low pass filter arrangement used in ADSL splitter for limiting unwanted transient signals.

However, although the known solutions improve POTS transient suppression without increasing the number of components, their stopband parameters are not standard compliant. Current standard compliant implementations use a passive 5^{th} order low pass filter, again with bulky coils. By reducing the number of cores on the POTS splitter, the known solutions thereby reduce the filter order as a consequence of which they are no longer standard compliant.

Furthermore, the POTS splitter must have sufficient performance. This means the combination of filtering performance, transient suppression, insertion loss and return loss should be sufficient. Transient suppression is not always good enough for 3^{rd} and even for 4^{th} order designs. POTS transients occurring on today's POTS splitters can induce many bit errors on the DSL service.

An object of the present invention is to provide a telecommunication filter arrangement of the above known type but which overcomes the drawbacks of being bulky, costly, complex and not sufficiently performant while being standard compliant.

According to the invention, this object is achieved due to the fact that said telecommunication filter arrangement further comprises a sensing device coupled between said first filter port and said first filter cell and to an input of a sensing circuit adapted to couple additional components to the windings of the transformer of said first filter cell.
Aspects of the present invention provide a telecommunication filter arrangement as set forth in the independent claim 1.

In this way, although the filter arrangement only comprises two filter cells, the order of the filter can be increased dynamically, when needed, by decoupling from the windings the additional components forming correction cells. Requirements for voice quality will for instance only be fulfilled in speech mode (after off-hook). In speech (voice) mode stopband requirements can be relaxed and the order of the filter can be kept lower. In this mode, the first filter cell together with the additional components will no longer act as a filter cell but as a voice quality correction and improvement cell.

Some other POTS related phenomena do require good stopband. The sensing circuit will detect high currents through the splitter and will decide to increase the order of the splitter by removing the additional components and thus transforming the correction cell into the single first filter cell by increasing the order of the filter from a 3^{rd} order filter with correction cell for POTS into a 5^{th} order splitter with good transient suppression. In this way unwanted disturbances of the DSL service due to POTS transients will be reduced.-Decision to switch to a higher order for improving transient suppression is taken based on the current sensed by the sensing circuit.

As a result, the transient suppression capability is improved leading to better performance, an existing 3^{rd} order splitter can be made standard compliant, i.e. upgraded to a 5^{th} order filter, while maintaining a reduced volume of only two filter cells or cores.

Another characterizing embodiment of the present invention is that said first filter port comprises a first filter terminal and a second filter terminal, whilst said second filter port comprises a third filter terminal and a fourth filter terminal, that said first filter cell comprises a first transformer with a first winding and a second winding, whilst said second filter cell comprises a second transformer with a third winding and a fourth winding, that said filter arrangement further comprising a filter capacitor coupled between the first and the second filter terminal, and said parallel capacitor coupled between the junction points of the first and the third winding with the second and the fourth winding, and that said sensing device comprises a first sensing component coupled between said first filter terminal and said first winding, and a second sensing component coupled between said second filter terminal and said second winding.

The sensing components are used to trigger the sensing circuits which in turn control the coupling of the additional components to the windings of the transformer of the first filter cell.

The present invention is further characterized in that said sensing circuit comprises a first sensing part coupled to said first sensing component and adapted to control a first switch for coupling a first resistor in parallel with said first winding, and in that said sensing circuit further comprises a second sensing part coupled to said second sensing component and adapted to control a second switch for coupling a second resistor in parallel with said second winding.

The first and second resistors constitute the above additional components and are known as voice correction resistors that can be coupled to the windings of the transformer of the first filter cell for increasing the order of the filter arrangement.

In a preferred characterizing embodiment of the present invention, the transformer of said first filter cell further comprises a control winding and said sensing circuit is adapted to control a switch for coupling a correction resistor across said control winding.

The control winding and correction resistor, also known as POTS correction resistor, are then the additional components coupled to the windings of the transformer of the first filter cell.

In this preferred characterizing embodiment, said sensing circuit is only coupled to the first sensing component of said sensing device.

This preferred embodiment dramatically reduces the number of components of the filter arrangement.

In another preferred characterizing embodiment of the present invention, said parallel capacitor is coupled between the junction points of the first and the third winding with the second and the fourth winding via a series connected circuit comprising the parallel connection of a resistor and a coil.

The circuit comprising the parallel capacitor in series with the resistor and the coil allows improving the transient suppression both for the 3^{rd} and for the 5^{th} order design.

Further characterizing embodiments of the present telecommunication filter arrangement are mentioned in the appended claims.

It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

The above and other objects and features of the invention will become more apparent and the invention itself will be best understood by referring to the following description of an embodiment taken in conjunction with the accompanying drawings wherein:
Fig. 1 represents a telecommunication filter arrangement according to the invention;
Fig. 2 represents a preferred embodiment of the filter arrangement of Fig. 1;
Fig. 3 represents an improved version of the filter arrangement of Fig. 1; and
Fig. 4 represents an improved version of the filter arrangement of Fig. 2.

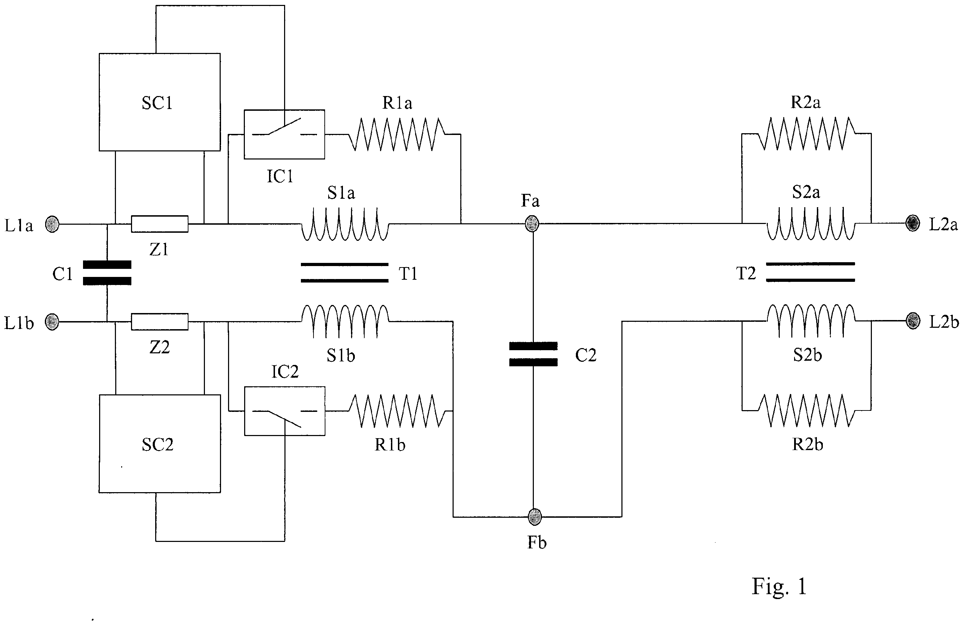

The telecommunication filter arrangement shown at Fig. 1 is a splitter for separating a Digital Subscriber Line ADSL from a Plain Old Telephone Service POTS in a telecommunication network. It can also be used for other DSL, such as VDSL2, services. In more detail, the filter arrangement, hereafter merely called filter or splitter, is used to prevent high frequency ADSL / VDSL signals from interfering with the lower frequency POTS signals, and to prevent high frequency transients from the POTS from interfering with the ADSL or VDSL signals. To this end, the filter comprises, between a first filter port and a second filter port, the cascade coupling of a first filter cell and a second filter cell.

The first filter port is coupled to a POTS subscriber set, whilst the second filter port is coupled to a telecommunication line of an ADSL / VDSL telecommunication system.

The first filter port comprises a first filter terminal L1a and a second filter terminal L1b, whilst the second filter port comprises a third filter terminal L2a and a fourth filter terminal L2b. The first filter cell comprises a first transformer T1 with a first winding S1a and a second winding S1b, whilst the second filter cell comprises a second transformer T2 with a third winding S2a and a fourth winding S2b. The filter further comprises a filter capacitor C1 coupled between the first L1a and the second L1b filter terminal, and a parallel capacitor C2. The capacitor C2 is coupled between the junction point of the first winding S1a and the third S2a winding, and the junction point of the second winding S1b and the fourth winding S2b, i.e. at the junction point of the two transformers T1 and T2.

The basic idea of the present invention is that the order of the filter can be dynamically increased when needed, e.g. for requirements for voice quality that will only be fulfilled in speech mode (after off-hook). In speech (voice) mode stopband requirements can be relaxed and the order of the filter can be kept low. Some other POTS related phenomena do require good stopband.

In order to achieve such requirements, the filter further comprises a sensing device coupled between the first filter port and the first filter cell and to an input of a sensing circuit adapted to couple additional components, e.g. resistors, to the windings of the transformer T1 of the first filter cell.

In more detail, the sensing device, also known as correction cell, comprises a first sensing component Z1 coupled between the first filter terminal L1a and the first winding S1a, and a second sensing component Z2 coupled between the second filter terminal L1b and the second winding S1b.

The sensing circuit comprises a first sensing part SC1 coupled to the first sensing component Z1 and adapted to control a first switch IC1 for coupling a first resistor R1a, as additional component, in parallel with the first winding S1a. This sensing circuit further comprises a second sensing part SC2 coupled to the second sensing component Z2 and adapted to control a second switch IC2 for coupling a second resistor R1b, as another additional component, in parallel with the second winding S1b. The resistors R1a and R1b are known as POTS correction resistors.

High currents thru the splitter are detected and the order will be increased in order to reduce unwanted disturbance of the DSL service due to POTS transients. In this way, the splitter can switch between 3^{rd} and 5^{th} order as a function of the current. Decision to switch to a higher order for improving transient suppression is thus based on current sensing.

In voice mode, currents are smaller than 80mA and the switches IC1 and IC2 are closed. In this mode, the splitter is a third order design with a stop-band that is good enough to suppress unwanted POTS voice components. When the switches IC 1 and IC2 are closed, the impedances R1a, S1a and R1b, S1b guarantee POTS voice quality.

Unwanted POTS transients are generated by POTS signaling and can disturb the DSL service. They occur at currents higher than 80mA. At that moment in time, voice quality does not need to be guaranteed but good transient suppression is desirable. To achieve this, the switches IC1 and IC2 are opened and the POTS correction resistors R1a and R1b are disconnected from the correction cell and thus changing the order of the filter.

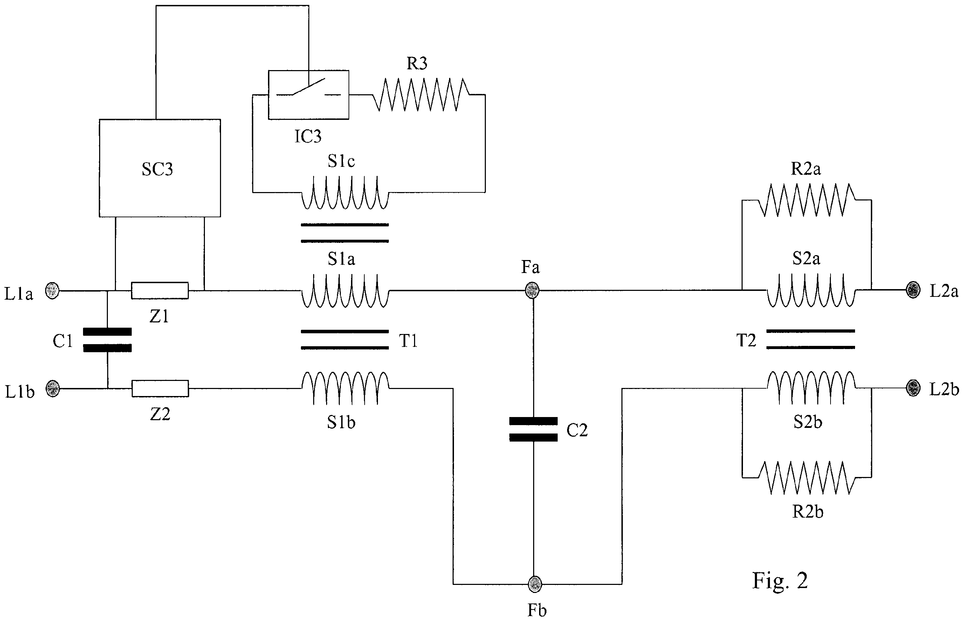

A preferred embodiment of the splitter is shown at Fig. 2. Therein, the transformer T1 of the first filter cell T1, S1a, S1b further comprises a third or control winding S1c. Consequently, the two sensing circuits SC1 and SC2 are replaced by a single sensing circuit SC3, similar to the previous SC1 and coupled to the sensing component Z1. The sensing components Z2 remaining for the balance of the telecommunication lines.

The sensing circuit SC3 is adapted to control a switch IC3 for coupling a POTS correction resistor R3, as additional component, across the control winding S1c.

This preferred embodiment dramatically reduces the number of components of the filter arrangement by the suppression of the second sensing circuit SC2, the second switch IC2 and the second resistor R1b.

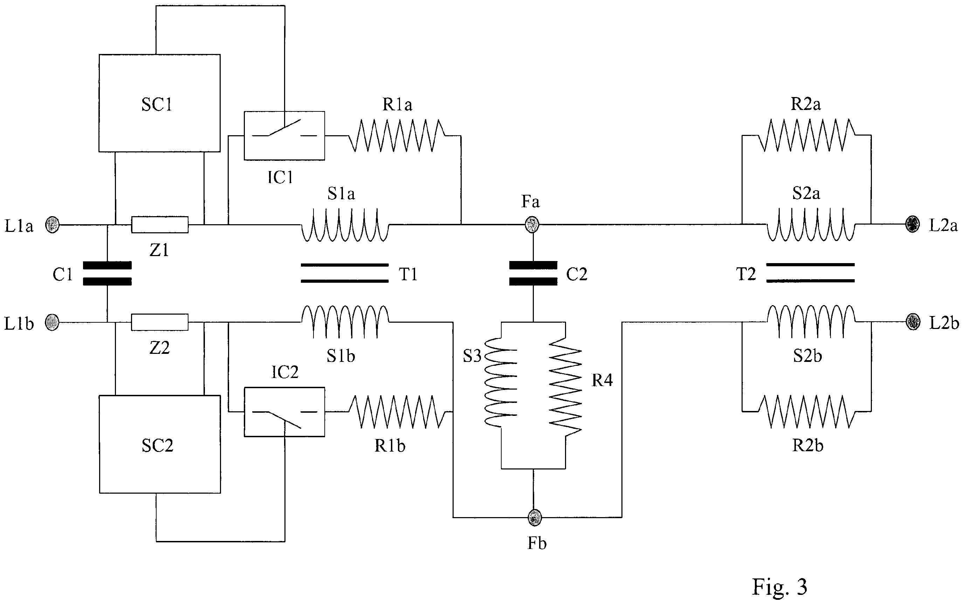

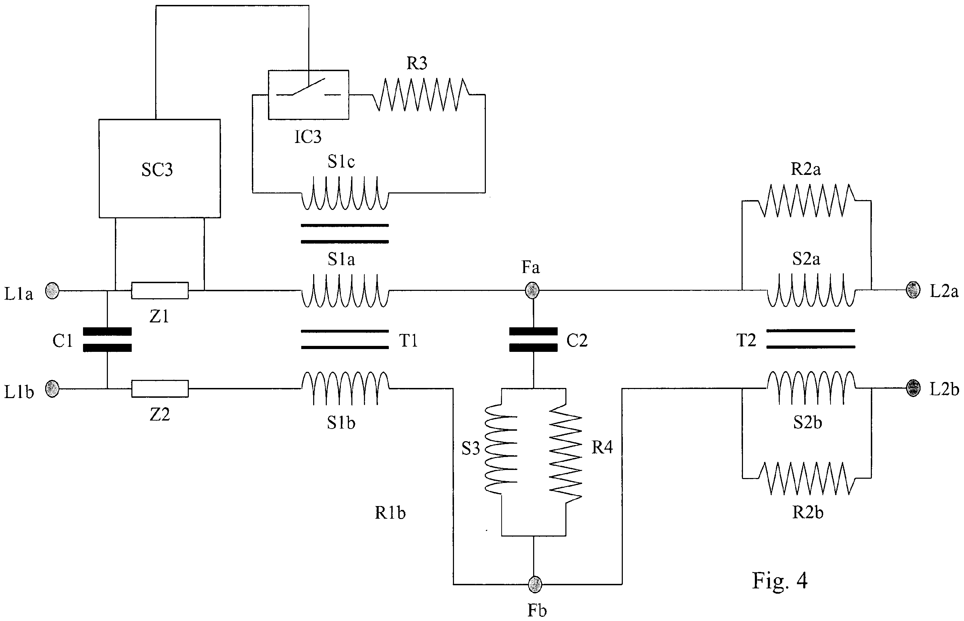

An improvement of the present splitter is shown at Figs. 3 and 4, based on the design of the Figs. 1 and 2 respectively. Therein, the parallel capacitor C2 is series connected with a circuit comprising the parallel connection of a resistor R4 and a coil S3. The whole is coupled between the junction point of the first winding S1a and the third S2a winding, and the junction point of the second winding S1b and the fourth winding S2b. The circuit comprising the parallel capacitor C2 in series with the resistor R4 and the coil S3 allows improving the transient suppression both for the 3^{rd} and for the 5^{th} order design.

Still another variant embodiment of the above described filter or splitter is shown in all the Figs. Therein, the second filter cell further comprises a third resistor R2a coupled in parallel over the third winding S2a of the second transformer T2, and a fourth resistor R2b coupled in parallel over the fourth winding S2b of the second transformer.

These resistors R2a and R2b allow improving the transient suppression induced by the POTS.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. A telecommunication filter arrangement comprising a first filter cell (T1, S1a, S1b) and a second filter cell (T2, S2a, S2b) coupled in cascade between a first filter port (L1a, L1b) and a second filter port (L2a, L2b),
each filter cell comprising a transformer (T 1; T2) and said filter arrangement further comprising a parallel capacitor (C2) at the junction point of the two transformers and coupled between the windings (S1a, S1b; S2a, S2b) of each of said transformers,
**characterized in that** said telecommunication filter arrangement further comprises a current sensing device (Z1; Z2) coupled between said first filter port (L1a, L1b) and said first filter cell (T1, S1a, S1b) and to an input of a current sensing circuit (SC1; SC2; SC3) arranged for detecting a current exceeding a threshold level due to a POTS transient and adapted to couple additional components (R1a; R1b; S1c, R3) to the windings (S1a, S1b) of the transformer (T1) of said first filter cell, wherein the coupling is such that an order of the filter is changed,
**in that** said first filter port comprises a first filter terminal (L1a) and a second filter terminal (L1b),
**and in that** said filter arrangement further comprises a filter capacitor (C1) coupled between the first (L1a) and the second (L1b) filter terminal.

2. The telecommunication filter arrangement according to claim 1,
**characterized in that** said second filter port comprises a third filter terminal (L2a) and a fourth filter terminal (L2b),
**in that** said first filter cell comprises a first transformer (T 1) with a first winding (S1a) and a second winding (S1b), whilst said second filter cell comprises a second transformer (T2) with a third winding (S2a) and a fourth winding (S2b),
**in that** said parallel capacitor (C2) coupled between the junction points of the first (S1a) and the third (S2a) winding with the second (S1b) and the fourth (S2b) winding,
**and in that** said current sensing device comprises a first sensing component (Z1) coupled between said first filter terminal (L1a) and said first winding (S1a), and a second sensing component (Z2) coupled between said second filter terminal (L1b) and said second winding (S1b).

3. The telecommunication filter arrangement according to claim 2,
**characterized in that** said current sensing circuit comprises a first sensing part (SC1) coupled to said first sensing component (ZI) and adapted to control a first switch (IC1) for coupling a first resistor (R1a) in parallel with said first winding (S1a),
**and in that** said current sensing circuit further comprises a second sensing part (SC2) coupled to said second sensing component (Z2) and adapted to control a second switch (IC2) for coupling a second resistor (R1b) in parallel with said second winding (S1b).

4. The telecommunication filter arrangement according to claim 1,
**characterized in that** the transformer (T1) of said first filter cell (T1, S1a, S1b) further comprises a control winding (S1c),
**and in that** said current sensing circuit (SC3) is adapted to control a switch (IC3) for coupling a correction resistor (R3) across said control winding.

5. The telecommunication filter arrangement according to the claims 2 and 4,
**characterized in that** said current sensing circuit (SC3) is only coupled to the first sensing component (Z1) of said current sensing device (Z1, Z2).

6. The telecommunication filter arrangement according to claim 2,
**characterized in that** said parallel capacitor (C2) is coupled between the junction points of the first (S1a) and the third (S2a) winding with the second (S1b) and the fourth (S2b) winding via a series connected circuit comprising the parallel connection of a resistor (R4) and a coil (S3).

7. The telecommunication filter arrangement according to claim 2,
**characterized in that** said second filter cell further comprises a third resistor (R2a) coupled in parallel over the third winding (S2a) of said second transformer (T2), and a fourth resistor (R2b) coupled in parallel over the fourth winding (S2b) of said second transformer.

8. The telecommunication filter arrangement according to claim 1,
**characterized in that** said first filter arrangement port (L 1a, L 1b) is coupled to a Plain Old Telephone Service POTS subscriber set,
**and in that** said second filter arrangement port (L2a, L2b) is coupled to a telecommunication line of a Digital Subscriber Line DSL telecommunication system.

## Patentansprüche

1. Telekommunikationsfilteranordnung, umfassend eine erste Filterzelle (T1, S1a, S1b) und eine zweite Filterzelle (T2, S2a, S2b), die in Kaskade zwischen einen ersten Filterport (L1a, L1b) und einen zweiten Filterport (L2a, L2b) gekoppelt sind,
wobei jede Filterzelle einen Transformator (T1; T2) umfasst und die besagte Filteranordnung weiterhin einen Parallelkondensator (C2) an dem Knotenpunkt der zwei Transformatoren umfasst, der zwischen die Wicklungen (S1a, S1b; S2a, S2b) von jedem der besagten Transformatoren gekoppelt ist,
**dadurch gekennzeichnet, dass** die besagte Telekommunikationsfilteranordnung weiterhin eine Strommessvorrichtung (Z1; Z2) umfasst, die zwischen den besagten ersten Filterport (L1a, L1b) und die besagte erste Filterzelle (T1, S1a, S1b) und an einen Eingang eines Strommesskreises (SC1; SC2; SC3) gekoppelt ist, der zum Erkennen eines Stroms angeordnet ist, der einen Grenzwert aufgrund eines POTS-Störsignals überschreitet, und angepasst ist, um zusätzliche Komponenten (R1a; R1b; S1c, R3) an die Wicklungen (S1a, S1b) des Transformators (T1) der besagten ersten Filterzelle zu koppeln, wobei die Kopplung so ist, dass eine Reihenfolge des Filters geändert wird,
dadurch, dass der besagte erste Filterport einen ersten Filteranschluss (L1a) und einen zweiten Filteranschluss (L1b) umfasst,
und dadurch, dass die besagte Filteranordnung weiterhin einen Filterkondensator (C1) umfasst, der zwischen den ersten (L1a) und den zweiten (L1b) Filteranschluss gekoppelt ist.

2. Telekommunikationsfilteranordnung nach Anspruch 1,
**dadurch gekennzeichnet, dass** der besagte zweite Filterport einen dritten Filteranschluss (L2a) und einen vierten Filteranschluss (L2b) umfasst,
dadurch, dass die besagte erste Filterzelle einen ersten Transformator (T1) mit einer ersten Wicklung (S1a) und einer zweiten Wicklung (S1b) umfasst, während die besagte zweite Filterzelle einen zweiten Transformator (T2) mit einer dritten Wicklung (S2a) und einer vierten Wicklung (S2b) umfasst,
dadurch, dass der besagte Parallelkondensator (C2) zwischen die Knotenpunkte der ersten (S1a) und der dritten (S2a) Wicklung mit der zweiten (S1b) und der vierten (S2b) Wicklung gekoppelt ist,
und dadurch, dass die besagte Strommessvorrichtung eine erste Messkomponente (Z1), die zwischen den besagten ersten Filteranschluss (L1a) und die besagte erste Wicklung (S1a) gekoppelt ist, und eine zweite Messkomponente (Z2) umfasst, die zwischen den besagten zweiten Filteranschluss (L1b) und die besagte zweite Wicklung (S1b) gekoppelt ist.

3. Telekommunikationsfilteranordnung nach Anspruch 2,
**dadurch gekennzeichnet, dass** der besagte Strommesskreis ein erstes Messteil (SC1) umfasst, das an die besagte erste Messkomponente (Z1) gekoppelt und angepasst ist, um einen ersten Schalter (IC1) zum Koppeln eines ersten Widerstands (R1a) in Parallelschaltung mit der besagten ersten Wicklung (S1a) zu steuern,
und dadurch, dass der besagte Strommesskreis weiterhin ein zweites Messteil (SC2) umfasst, das an die besagte zweite Messkomponente (Z1) gekoppelt und angepasst ist, um einen zweiten Schalter (IC2) zum Koppeln eines zweiten Widerstands (R1 b) in Parallelschaltung mit der besagten zweiten Wicklung (S1 b) zu steuern.

4. Telekommunikationsfilteranordnung nach Anspruch 1,
**dadurch gekennzeichnet, dass** der Transformator (T1) der besagten ersten Filterzelle (T1, S1a, S1b) weiterhin eine Steuerwicklung (S1c) umfasst,
und dadurch, dass der besagte Strommesskreis (SC3) angepasst ist, um einen Schalter (IC3) zum Koppeln eines Korrekturwiderstands (R3) durch die besagte Steuerwicklung zu steuern.

5. Telekommunikationsfilteranordnung nach Anspruch 2 und 4,
**dadurch gekennzeichnet, dass** der besagte Strommesskreis (SC3) nur an die erste Messkomponente (Z1) der besagten Strommessvorrichtung (Z1, Z2) gekoppelt ist.

6. Telekommunikationsfilteranordnung nach Anspruch 2,
**dadurch gekennzeichnet, dass** der besagte Parallelkondensator (C2) zwischen die Knotenpunkte der ersten (S1a) und der dritten (S2a) Wicklung mit der zweiten (S1b) und der vierten (S2b) Wicklung über einen in Reihe geschalteten Kreis, umfassend die Parallelverbindung eines Widerstands (R4) und einer Spule (S3), gekoppelt ist.

7. Telekommunikationsfilteranordnung nach Anspruch 2,
**dadurch gekennzeichnet, dass** die besagte zweite Filterzelle weiterhin einen dritten Widerstand (R2a) umfasst, der in Parallelschaltung über die dritte Wicklung (S2a) des besagten zweiten Transformators (T2) gekoppelt ist, und einen vierten Widerstand (R2b), der in Parallelschaltung über die vierte Wicklung (S2b) des besagten zweiten Transformators gekoppelt ist.

8. Telekommunikationsfilteranordnung nach Anspruch 1,
**dadurch gekennzeichnet, dass** der besagte erste Filteranordnungsport (L1a, L1b) an eine Plain-Old-Telephone-Service-POTS-Teilnehmergruppe gekoppelt ist,
und dadurch, dass der besagte zweite Filteranordnungsport (L2a, L2b) an eine Telekommunikationsleitung eines Telekommunikationssystems mit digitalem Teilnehmeranschluss DSL gekoppelt ist.

## Revendications

1. Système de filtre de télécommunication comprenant une première cellule de filtre (T1, S1a, S1b) et une deuxième cellule de filtre (T2, S2a, S2b) connectées en cascade entre un premier port de filtre (L1a, L1b) et un deuxième port de filtre (L2a, L2b),
chaque cellule de filtre comprenant un transformateur (T1 ; T2) et ledit système de filtre comprenant en outre un condensateur en parallèle (C2) au niveau du point de jonction des deux transformateurs et connecté entre les enroulements (S1a, S1b ; S2a, S2b) de chacun desdits transformateurs,
**caractérisé en ce que** ledit système de filtre de télécommunication comprend en outre un dispositif de détection de courant (Z1 ; Z2) connecté entre ledit premier port de filtre (L1a, L1b) et ladite première cellule de filtre (T1, S1a, S1b) et à une entrée d'un circuit de détection de courant (SC1 ; SC2 ; SC3) conçu pour détecter un courant dépassant un niveau de seuil en raison d'un transitoire de service téléphonique traditionnel et adapté pour connecter des composants supplémentaires (R1a ; R1b ; S1c ; R3) aux enroulements (S1a, S1b) du transformateur (T1) de ladite première cellule de filtre, la connexion étant telle que l'ordre du filtre est modifié,
**en ce que** ledit premier port de filtre comprend une première borne de filtre (L1a) et une deuxième borne de filtre (L1b),
et **en ce que** ledit système de filtre comprend en outre un condensateur de filtrage (C1) connecté entre la première (L1a) et la deuxième (L1b) borne du filtre.

2. Système de filtre de télécommunication selon la revendication 1,
**caractérisé en ce que** ledit deuxième port de filtre comprend une troisième borne de filtre (L2a) et une quatrième borne de filtre (L2b),
**en ce que** ladite première cellule de filtre comprend un premier transformateur (T1) avec un premier enroulement (S1a) et un deuxième enroulement (S1b), tandis que ladite deuxième cellule de filtre comprend un deuxième transformateur (T2) avec un troisième enroulement (S2a) et un quatrième enroulement (S2b),
**en ce que** ledit condensateur en parallèle (C2) est connecté entre les points de jonction du premier (S1a) et du troisième (S2a) enroulements avec le deuxième (S1b) et le quatrième (S2b) enroulements,
et **en ce que** ledit dispositif de détection de courant comprend un premier composant de détection (Z1) connecté entre ladite première borne de filtre (L1a) et ledit premier enroulement (S1a), et un deuxième composant de détection (Z2) connecté entre ladite deuxième borne de filtre (L1b) et ledit deuxième enroulement (S1 b).

3. Système de filtre de télécommunication selon la revendication 2,
**caractérisé en ce que** ledit circuit de détection de courant comprend une première partie de détection (SC1) connectée audit premier composant de détection (Z1) et adaptée pour commander un premier interrupteur (IC1) destiné à connecter une première résistance (R1a) en parallèle avec ledit premier enroulement (S1a),
et **en ce que** ledit circuit de détection de courant comprend en outre une deuxième partie de détection (SC2) connectée audit deuxième composant de détection (Z2) et adaptée pour commander un deuxième interrupteur (IC2) destiné à connecter une deuxième résistance (R1 b) en parallèle avec ledit deuxième enroulement (S1b).

4. Système de filtre de télécommunication selon la revendication 1,
**caractérisé en ce que** le transformateur (T1) de ladite première cellule de filtre (T1, S1a, S1b) comprend en outre un enroulement de commande (S1c),
et **en ce que** ledit circuit de détection de courant (SC3) est adapté pour commander un interrupteur (IC3) destiné à connecter une résistance de correction (R3) aux bornes dudit enroulement de commande.

5. Système de filtre de télécommunication selon les revendications 2 et 4,
**caractérisé en ce que** ledit circuit de détection de courant (SC3) est connecté uniquement au premier composant de détection (Z1) dudit dispositif de détection de courant (Z1, Z2).

6. Système de filtre de télécommunication selon la revendication 2,
**caractérisé en ce que** ledit condensateur en parallèle (C2) est connecté entre les points de jonction du premier (S1a) et du troisième (S2a) enroulements avec le deuxième (S1b) et le quatrième (S2b) enroulements via un circuit connecté en série comprenant la connexion en parallèle d'une résistance (R4) et d'une bobine (S3).

7. Système de filtre de télécommunication selon la revendication 2,
**caractérisé en ce que** ladite deuxième cellule de filtre comprend en outre une troisième résistance (R2a) connectée en parallèle sur le troisième enroulement (S2a) dudit deuxième transformateur (T2), et une quatrième résistance (R2b) connectée en parallèle sur le quatrième enroulement (S2b) dudit deuxième transformateur.

8. Système de filtre de télécommunication selon la revendication 1,
**caractérisé en ce que** ledit premier port du système de filtre (L1a, L1b) est connecté à un poste d'abonné du service téléphonique traditionnel POTS,
et **en ce que** ledit deuxième port du système de filtre (L2a, L2b) est connecté à une ligne de télécommunication d'un système de télécommunication de ligne d'abonné numérique DSL.
